# EUROPEAN PATENT APPLICATION

(11) **EP 3 598 232 A1**
(43) Date of publication of application: **22.01.2020**
(21) Application number: 18767624.2
(22) Date of filing: 26.01.2018
(51) Int. Cl.: G03F 7/004, G03F 7/038, G03F 7/20

(54) **RADIATION SENSITIVE COMPOSITION AND PATTERN FORMING METHOD**

(30) Priority: 13.03.2017 JP 2017047909
(71) Applicant: JSR Corporation, Minato-ku Tokyo 105-8640 (JP)
(72) Inventor: NAKAGAWA Hisashi, Tokyo 105-8640 (JP); MINEGISHI Shinya, Tokyo 105-8640 (JP); SHIRATANI Motohiro, Tokyo 105-8640 (JP)
(74) Representative: TBK
(86) International application number: PCT/JP2018/002597
(87) International publication number: WO 2018/168221

(57) **Abstract**

A radiation-sensitive composition contains: a compound that includes a metal-oxygen covalent bond; and a solvent, wherein the metal is a metal of an element belonging to any one of period 4 to period 7 of group 3 to group 15 in periodic table, and the solvent contains: a first solvent having a viscosity at 20 °C of no greater than 10 mPa·s and a vapor pressure at 20 °C of no greater than 5 kPa; and a second solvent having a van der Waals volume of no greater than 150 Å³, and being different from the first solvent, the second solvent being: water; a monovalent alcohol represented by R¹-OH; R²-COOH; or a combination thereof, wherein R¹ represents a monovalent organic group having 1 to 4 carbon atoms, and R² represents a monovalent organic group having 1 to 30 carbon atoms.

## Description

### [TECHNICAL FIELD]

The present invention relates to a radiation-sensitive composition and a pattern-forming method.

### [BACKGROUND ART]

A radiation-sensitive composition for use in micro fabrication by lithography generates an acid at a light-exposed region upon an irradiation with an electromagnetic wave such as a far ultraviolet ray (e.g., ArF excimer laser beam, KrF excimer laser beam, etc.) or an extreme ultraviolet ray (EUV), a charged particle ray such as an electron beam. A chemical reaction in which the acid serves as a catalyst causes the difference in rates of dissolution in a developer solution, between light-exposed regions and light-unexposed regions to form a pattern on a substrate.

Such radiation-sensitive compositions are demanded to have improved resist performances along with miniaturization in processing techniques. To meet such demands, types, molecular structures and the like of polymers, acid generating agents and other components which may be used in the compositions have been investigated, and combinations thereof have been further investigated in detail (see, Japanese Unexamined Patent Application, Publication Nos. H11-125907, H8-146610 and 2000-298347).

### [PRIOR ART DOCUMENTS]

### [PATENT DOCUMENTS]

Patent Document 1: Japanese Unexamined Patent Application, Publication No. H11-125907
Patent Document 2: Japanese Unexamined Patent Application, Publication No. H8-146610
Patent Document 3: Japanese Unexamined Patent Application, Publication No. 2000-298347

### [SUMMARY OF THE INVENTION]

### [PROBLEMS TO BE SOLVED BY THE INVENTION]

At present, miniaturization of patterns has proceeded to a level for line widths of no greater than 40 nm, but radiation-sensitive compositions have been needed to be still superior in resist performances, as well as coating characteristics and storage stability of the radiation-sensitive composition. However, the conventional radiation-sensitive compositions have not satisfied all these needs.

The present invention was made in view of the foregoing circumstances, and an object of the invention is to provide a radiation-sensitive composition superior in coating characteristics and storage stability, and a pattern-forming method in which the radiation-sensitive composition is used.

### [Means for Solving the Problems]

According to a first aspect of the invention made for solving the aforementioned problems, a radiation-sensitive composition comprises: a compound comprising a metal-oxygen covalent bond; and a solvent, wherein the metal is a metal of an element belonging to any one of period 4 to period 7 of group 3 to group 15 in periodic table, and the solvent comprises: a first solvent having a viscosity at 20 °C of no greater than 10 mPa·s and a vapor pressure at 20 °C of no greater than 5 kPa; and a second solvent having a van der Waals volume of no greater than 150 Å³, and being different from the first solvent, the second solvent being: water; a monovalent alcohol represented by R¹-OH; R²-COOH; or a combination thereof, wherein R¹ represents a monovalent organic group having 1 to 4 carbon atoms, and R² represents a monovalent organic group having 1 to 30 carbon atoms.

The term "covalent bond" as referred to herein means a chemical bond formed by sharing an electronic pair by two atoms, and a coordinate bond is excluded from the chemical bond. Also, the covalent bond should not include an ionic bond. Note that 1 Å denotes 1 x 10⁻¹⁰ m.

According to a second aspect of the invention made for solving the aforementioned problems, a pattern-forming method comprising:
applying the radiation-sensitive composition of the first aspect directly or indirectly on a substrate; exposing with an extreme ultraviolet ray or an electron beam, a film formed after the applying; and developing the film exposed.

### [Effects of the Invention]

The radiation-sensitive composition and the pattern-forming method of the aspects of the present invention enable a radiation-sensitive composition superior in coating characteristics and storage stability, and a pattern-forming method using the same to be provided. Therefore, these can be suitably used in manufacture of semiconductor devices in which further progress of miniaturization is expected in the future.

### [Description of Embodiments]

### Radiation-Sensitive Composition

The radiation-sensitive composition contains a compound having a metal-oxygen covalent bond (hereinafter, may be also referred to as "(A) compound" or "compound (A)"), and a solvent (hereinafter, may be also referred to as "(B) solvent" or "solvent (B)"). The radiation-sensitive composition may also contain optional component(s) within a range not leading to impairment of the effects of the present invention, and may contain a metal compound other than the compound (A). Each component will be described below.

### (A) Compound

The compound (A) is a metal compound having a metal-oxygen covalent bond, and is preferably not an ionic compound such as a salt. Due to having the metal-oxygen covalent bond, the compound (A) is capable of changing a solubility in a developer solution through a structural change or a change of the group bonding to the metal atom of the compound (A) upon an exposure, thereby enabling a pattern to be formed.

The compound (A) is a component that includes a metal atom (y). The metal atom (y) is a metal of an element belonging to any one of period 4 to period 7 of group 3 to group 15 in periodic table.

Examples of the metal atoms from group 3 include a scandium atom, an yttrium atom, a lanthanum atom, a cerium atom and the like.

Examples of the metal atoms from group 4 include a titanium atom, a zirconium atom, a hafnium atom and the like.

Examples of the metal atoms from group 5 include a vanadium atom, a niobium atom, a tantalum atom and the like.

Examples of the metal atoms from group 6 include a chromium atom, a molybdenum atom, a tungsten atom and the like.

Examples of the metal atoms from group 7 include a manganese atom, a rhenium atom and the like.

Examples of the metal atoms from group 8 include an iron atom, a ruthenium atom, an osmium atom and the like.

Examples of the metal atoms from group 9 include a cobalt atom, a rhodium atom, an iridium atom and the like.

Examples of the metal atoms from group 10 include a nickel atom, a palladium atom, a platinum atom and the like.

Examples of the metal atoms from group 11 include a copper atom, a silver atom, a gold atom and the like.

Examples of the metal atoms from group 12 include a zinc atom, a cadmium atom, a mercury atom and the like.

Examples of the metal atoms from group 13 include an aluminum atom, a gallium atom, an indium atom and the like.

Examples of the metal atoms from group 14 include a germanium atom, a tin atom, a lead atom and the like.

Examples of the metal atoms from group 15 include an antimony atom, a bismuth atom and the like.

The metal atom (y) is preferably an atom from group 4, group 5, group 6 and group 14, and more preferably titanium, zirconium, hafnium, tantalum, tungsten or tin.

The compound (A) may include other atom than the metal atom and an oxygen atom. Examples of the other atom include a boron atom, a carbon atom, a hydrogen atom, a nitrogen atom, a phosphorus atom, a sulfur atom, a halogen atom, and the like.

The lower limit of the proportion of the total inorganic component that includes the metal atom in the compound (A) is preferably 30% by mass, more preferably 40% by mass, and still more preferably 50% by mass. Meanwhile, the upper limit of the proportion of the total inorganic component contained is preferably 85% by mass. The proportion of the total inorganic component that includes the metal atom may be measured with a differential thermal balance (TG/DTA). When the proportion of the total inorganic component that includes the metal atom falls within the above range, structural change of the compound (A) by exposure light can be more effectively facilitated, thereby consequently enabling the sensitivity of the radiation-sensitive composition to be more improved.

Constituents of the compound (A) are preferably a metal oxide that includes the metal atom (y) and has a metal-oxygen covalent bond, and an organic acid (hereinafter, may be also referred to as "organic acid (a)"). The "organic acid" as referred to herein means an acidic organic compound, and the "organic compound" as referred to means a compound having at least one carbon atom. The compound (A) may contain one, or two or more types of the organic acid (a).

Due to containing the compound (A) being constituted from the metal atom (y) and the organic acid (a), the sensitivity of the radiation-sensitive composition is more improved. The improvement is considered to result from improved dispersibility of the compound (A) in the solvent through bonding of the organic acid (a) to the metal atom, for example.

The lower limit of pKa of the organic acid (a) is preferably 0, more preferably 1, still more preferably 1.5, and particularly preferably 3. Meanwhile, the upper limit of the pKa is preferably 7, more preferably 6, still more preferably 5.5, and particularly preferably 5. When the pKa of the organic acid (a) falls within the above range, it is possible to adjust the interaction with the metal atom to be moderately weak, thereby consequently enabling the sensitivity of the radiation-sensitive composition to be more improved. As used herein, in the case of the organic acid (a) being a polyvalent acid, the pKa of the organic acid (a) as referred to means a primary acid dissociation constant, i.e., a logarithmic value of a dissociation constant for dissociation of the first proton.

The organic acid (a) may be either a low molecular weight compound or a high molecular weight compound, and a low molecular weight compound is preferred in light of adjusting the interaction with the metal atom to be more appropriately weak. The "low molecular weight compound" as referred to means a compound having a molecular weight of no greater than 1,500, whereby the "high molecular weight compound" as referred to means a compound having a molecular weight of greater than 1,500. The lower limit of the molecular weight of the organic acid (a) is preferably 50, and more preferably 80.
Meanwhile, the upper limit of the molecular weight is preferably 1,000, more preferably 500, further more preferably 400, and particularly preferably 300. When the molecular weight of the organic acid (a) falls within the above range, it is possible to adjust the dispersibility of the compound (A) to be more appropriate, thereby consequently enabling the sensitivity of the radiation-sensitive composition to be more improved.

The organic acid (a) is exemplified by a carboxylic acid, a sulfonic acid, a sulfinic acid, an organic phosphinic acid, an organic phosphonic acid, a phenol, an enol, a thiol, an acid imide, an oxime, a sulfonamide, and the like.

Examples of the carboxylic acid include:
monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid and shikimic acid;
dicarboxylic acids such as oxalic acid, malonic acid, maleic acid, methylmalonic acid, fumaric acid, adipic acid, sebacic acid, phthalic acid and tartaric acid;
carboxylic acids having no less than 3 carboxy groups such as citric acid; and the like.

Examples of the sulfonic acid include benzenesulfonic acid, p-toluenesulfonic acid, and the like.

Examples of the sulfinic acid include benzenesulfinic acid, p-toluenesulfinic acid, and the like.

Examples of the organic phosphinic acid include diethylphosphinic acid, methylphenylphosphinic acid, diphenylphosphinic acid, and the like.

Examples of the organic phosphonic acid include methylphosphonic acid, ethylphosphonic acid, t-butylphosphonic acid, cyclohexylphosphonic acid, phenylphosphonic acid, and the like.

Examples of the phenol include: monovalent phenols such as phenol, cresol, 2,6-xylenol and naphthol;
divalent phenols such as catechol, resorcinol, hydroquinone and 1,2-naphthalenediol;
phenols having a valency of no less than 3 such as pyrogallol and 2,3,6-naphthalenetriol; and the like.

Examples of the enol include 2-hydroxy-3-methyl-2-butene, 3-hydroxy-4-methyl-3-hexene, and the like.

Examples of the thiol include mercaptoethanol, mercaptopropanol, and the like.

Examples of the acid imide include:
carboxylic imides such as maleimide and succinimide;
sulfonic imides such as a di(trifluoromethanesulfonic acid) imide and di(pentafluoroethanesulfonic acid) imide; and the like.

Examples of the oxime include:
aldoximes such as benzaldoxime and salicylaldoxime;
ketoximes such as diethylketoxime, methylethylketoxime and cyclohexanoneoxime; and the like.

Examples of the sulfonamide include methylsulfonamide, ethylsulfonamide, benzenesulfonamide, toluenesulfonamide, and the like.

In light of a more improvement of the sensitivity of the radiation-sensitive composition, the organic acid (a) is preferably the carboxylic acid, more preferably the monocarboxylic acid, and still more preferably methacrylic acid or benzoic acid.

The compound (A) is preferably the compound (A) constituted from the metal oxide that includes the metal atom (y), and the organic acid (a), more preferably the compound (A) constituted from the metal atom (y) and the carboxylic acid, and still more preferably the compound (A) constituted from the metal atom (y) and methacrylic acid or benzoic acid.

In the case in which the compound (A) includes a component derived from the organic acid (a), as a component other than the metal oxide that includes the metal atom (y), the lower limit of the percentage content of the component derived from the organic acid (a) in the compound (A) is preferably 1% by mass, more preferably 5% by mass, and still more preferably 10% by mass. Meanwhile, the upper limit of the percentage content is preferably 90% by mass, more preferably 70% by mass, and still more preferably 50% by mass. When the percentage content of the organic acid (a) falls within the above range, it is possible to adjust the dispersibility of the compound (A) to be further appropriate, thereby consequently enabling the sensitivity of the radiation-sensitive composition to be more improved.

Examples of the compound (A) include:
monobutyltin oxide, dibutyldiacetoxy tin, tetraethyldiacetoxy stannoxane or the like as a component that includes tin;
indium oxide sol or the like as a component that includes indium;
antimony trioxide or the like as a component that includes antimony;
bismuth trioxide or the like as a component that includes bismuth;
germanium oxide sol or the like as a component that includes germanium;
triisopropoxy aluminum or the like as a component that includes aluminum;
a reaction product of titanium(IV) alkoxide with the carboxylic acid, or the like as a component that includes titanium;
a reaction product of zirconium(IV) alkoxide with the carboxylic acid, a reaction product of zirconium(IV) β-diketonato with the carboxylic acid, or the like as a component that includes zirconium;
a reaction product of hafnium(IV) alkoxide, the carboxylic acid and water, a reaction product of hafnium(IV) β-diketonato with the carboxylic acid, or the like as a component that includes hafnium;
a reaction product of tantalum(V) alkoxide with a polyhydric alcohol, or the like as a component that includes tantalum;
a reaction product of tungsten(IV) chloride, a hydrogen peroxide and a hydroxycarboxylic acid, or the like as a component that includes tungsten.

Of these, monobutyltin oxide, tetraethyldiacetoxy stannoxane, indium oxide sol, germanium oxide sol and triisopropoxy aluminum, as well as a reaction product of titanium(IV) tri-n-butoxide stearate with maleic acid, a reaction product of zirconium(IV) n-butoxide with methacrylic acid, a reaction product of hafnium(IV) isopropoxide, trans-2,3-dimethyl acrylic acid and water, a reaction product of tantalum(V) ethoxide with diethylene glycol, and a reaction product of bis(cyclopentadienyl)tungsten(IV) dichloride, hydrogen peroxide and lactic acid are preferred.

The lower limit of the proportion of the compound (A) contained with respect to 100% by mass of the total solid content included in the radiation-sensitive composition is preferably 50% by mass, more preferably 65% by mass, and still more preferably 80% by mass. Meanwhile, the upper limit of the proportion of the compound (A) contained may be 100% by mass. When the solid content concentration of the compound (A) falls within the above range, the coating characteristics and the storage stability of the radiation-sensitive composition can be more improved. The "solid content" as referred to herein means components other than the solvent. The radiation-sensitive composition may contain one, or two or more types of the compound (A).

The compound (A) may constitute particles. The particles are exemplified by particles that include monobutyltin oxide, particles that include tetraethyldiacetoxy stannoxane, particles that include indium oxide sol, particles that include germanium oxide sol, particles that include a reaction product of hafnium(IV) alkoxide, carboxylic acid and water, particles that include a reaction product of tungsten(IV) chloride, hydrogen peroxide and lactic acid, and the like.

The lower limit of the average particle diameter of the particles is preferably 0.5 nm, and more preferably 0.8 nm. Meanwhile, the upper limit of the average particle diameter is preferably 20 nm, more preferably 10 nm, and still more preferably 4.0 nm.

When the average particle diameter of the particles in the compound (A) falls within the above range, a more improvement of the sensitivity of the radiation-sensitive composition is enabled.

### Synthesis Procedure of Compound (A)

The compound (A) used may be a commercially available metal compound, or may be synthesized by, for example, a procedure of carrying out a hydrolytic condensation reaction by using (b) a metal-containing compound described later, or the like. The "hydrolytic condensation reaction" as referred to herein means a reaction in which a hydrolyzable group included in the metal-containing compound (b) is hydrolyzed to give - OH, and two -OHs thus obtained undergo dehydrative condensation to form -O-.

### (b) Metal-containing compound

The metal-containing compound (b) may be: a metal compound (I) having a hydrolyzable group; a hydrolysis product of the metal compound (I) having a hydrolyzable group; a hydrolytic condensation product of the metal compound (I) having a hydrolyzable group; or a combination thereof. The metal compound (I) may be used either alone of one type, or in combination of two or more types thereof.

The hydrolyzable group is exemplified by a halogen atom, an alkoxy group, a carboxylate group, an acyloxy group, a -NRR group, and the like. Rs each independently represent a hydrogen atom or a monovalent organic group having 1 to 20 carbon atoms. Here, the monovalent organic group having 1 to 20 carbon atoms which may be represented by R is exemplified by: a monovalent hydrocarbon group having 1 to 20 carbon atoms; a monovalent group (g) having a divalent hetero atom-containing group between two adjacent carbon atoms or the end of the atomic bonding side of the hydrocarbon group having 1 to 20 carbon atoms; a monovalent group obtained by substituting with a hetero atom-containing group, a part or all of hydrogen atoms included in the hydrocarbon group and group (g); and the like.

Examples of the halogen atom include a fluorine atom, a chlorine atom, a bromine atom, an iodine, atom and the like.

Examples of the alkoxy group include a methoxy group, an ethoxy group, a n-propoxy group, an i-propoxy group, a butoxy group, and the like.

Examples of the acyloxy group include an acetoxy group, an ethylyloxy group, a propionyloxy group, a butyryloxy group, a t-butyryloxy group, a t-amylyloxy group, a n-hexanecarbonyloxy group, a n-octanecarbonyloxy group and the like.

Examples of the -NRR group include an unsubstituted amino group, a methylamino group, a dimethylamino group, a diethylamino group, a dipropylamino group and the like.

As the hydrolyzable group, an alkoxy group, an acyloxy group and a -NRR group are preferred, and an isopropoxy group, a butoxy group, an acetoxy group and a diethylamino group are more preferred.

In a case in which the metal-containing compound (b) is a hydrolytic condensation product of the metal compound (I), the hydrolytic condensation product of the metal compound (I) may be a hydrolytic condensation product of the metal (I) having a hydrolyzable group with a compound including a metalloid atom, within a range not leading to impairment of the effects of the embodiments of the present invention. In other words, the hydrolytic condensation product of the metal compound (I) may also include a metalloid atom within a range not leading to impairment of the effects of the embodiments of the present invention. The metalloid atom is exemplified by a boron atom, a tellurium atom and the like. The percentage content of the metalloid atom in the hydrolytic condensation product of the metal compound (I) is typically less than 50 atom% with respect to the entirety of the metal atom and the metalloid atom in the hydrolytic condensation product. The upper limit of the percentage content of the metalloid atom is preferably 30 atom% and more preferably 10 atom% with respect to the entirety of the metal atom and the metalloid atom in the hydrolytic condensation product.

The metal compound (I) is exemplified by compounds represented by the following formula (1) (hereinafter, may be also referred to as a "metal compound (1-1)"), and the like. By using the metal compound (1-1), forming a stable compound (A) is enabled, thereby consequently enabling the coating characteristics and the storage stability of the radiation-sensitive composition to be more improved.

LₐMY_{b} (1)

In the above formula (1), M represents the metal atom; L represents a ligand; a is an integer of 0 to 6, wherein in a case in which a is no less than 2, a plurality of Ls may be identical or different; Y represents a halogen atom, an alkoxy group, a carboxylate group, or a -NRR group, wherein Rs each independently represent a hydrogen atom or a monovalent organic group having 1 to 20 carbon atoms; and b is an integer of 2 to 6, wherein a plurality of Ys may be identical or different, and L represents a nonmetal group that does not fall under the definition of Y.

The metal atom represented by M is identical to that exemplified as the metal atom constituting the compound (A)

The ligand represented by L is exemplified by a monodentate ligand and a polydentate ligand.

Exemplary monodentate ligand includes a hydroxo ligand, a carboxy ligand, an amide ligand, an amine ligand, an olefin and the like.

Examples of the amido ligand include an unsubstituted amido ligand (NH2), a methylamido ligand (NHMe), a dimethylamido ligand (NMe₂), a diethylamido ligand (NEt₂), a dipropylamido ligand (NPr₂), and the like.

Examples of the amine ligand include a pyridine ligand, a trimethylamine ligand, a piperidine ligand, ammonia and the like.

Examples of the olefin include:
linear olefins such as ethylene and propylene;
cyclic olefins such as cyclopentene, cyclohexene and norbornene; and the like.

Exemplary polydentate ligand includes a ligand derived from a hydroxy acid ester, a ligand derived from a β-diketone, a ligand derived from a β-keto ester, a ligand derived from an α,α-dicarboxylic acid ester, a hydrocarbon having a *π* bond, diphosphine, and the like.

Examples of the hydroxy acid ester include glycolic acid esters, lactic acid esters, 2-hydroxycyclohexane-1-carboxylic acid esters, salicylic acid esters, and the like.

Examples of the β-diketone include 2,4-pentanedione, 3-methyl-2,4-pentanedione, 3-ethyl-2,4-pentanedione, and the like.

Examples of the β-keto ester include acetoacetic acid esters, α-alkyl-substituted acetoacetic acid esters, β-ketopentanoic acid esters, benzoylacetic acid esters, 1,3-acetonedicarboxylic acid esters, and the like.

Examples of the α,α-dicarboxylic acid ester include malonic acid diesters, α-alkyl-substituted malonic acid diesters, α-cycloalkyl-substituted malonic acid diesters, α-aryl-substituted malonic acid diesters, and the like.

Examples of the hydrocarbon having a *π* bond include:
chain dienes such as butadiene and isoprene;
cyclic dienes such as cyclopentadiene, methylcyclopentadiene, pentamethylcyclopentadiene, cyclohexadiene and norbornadiene;
aromatic hydrocarbons such as benzene, toluene, xylene, hexamethylbenzene, naphthalene and indene; and the like.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, and the like.

In the above formula (1), a is preferably 1 or 2, and more preferably 1.

Examples of the halogen atom which may be represented by Y include a fluorine atom, a chlorine atom, a bromine atom, an iodine atom, and the like.

Examples of the alkoxy group which may be represented by Y include a methoxy group, an ethoxy group, a n-propoxy group, an i-propoxy group, a butoxy group, and the like.

Examples of the acyloxy group which may be represented by Y include an acetoxy group, an ethylyloxy group, a butyryloxy group, a t-butyryloxy group, a t-amylyloxy group, a n-hexanecarbonyloxy group, a n-octanecarbonyloxy group, and the like.

Examples of the -NRR group which may be represented by Y include an unsubstituted amino group, a methylamino group, a dimethylamino group, a diethylamino group, a dipropylamino group and the like.

Y represents preferably an alkoxy group, an acyloxy group or a -NRR group, and more preferably an isopropoxy group, a butoxy group, an acetoxy group or a diethylamino group.

Preferably, b is 3 or 4, and more preferably 4. When b is the above specified value, it is possible to increase the percentage content of the metal oxide in the compound (A), whereby more effective promotion of the generation of the secondary electrons by the compound (A) is enabled. Consequently, a more improvement of the sensitivity of the radiation-sensitive composition is enabled.

As the metal-containing compound (b), a metal alkoxide that is neither hydrolyzed nor hydrolytic condensed, and a metal acyloxide that is neither hydrolyzed nor hydrolytically condensed are preferred.

Examples of the metal-containing compound (b) include indium(III) acetate, tetraethyldiacetoxy stannoxane, tetraisopropoxy germanium, monobutyltin oxide, zirconium tetra-n-butoxide, zirconium tetra-n-propoxide, zirconium tetraisopropoxide, hafnium tetraethoxide, indium triisopropoxide, hafnium tetraisopropoxide, hafnium tetrabutoxide, tantalum tetrabutoxide, tantalum pentaethoxide, tantalum pentabutoxide, tungsten tetrabutoxide, tungsten pentamethoxide, tungsten pentabutoxide, tungsten hexaethoxide, tungsten hexabutoxide, iron chloride, zinc diisopropoxide, zinc acetate dihydrate, tetrabutyl orthotitanate, titanium tetra-n-butoxide, titanium tetra-n-propoxide, zirconium di-n-butoxide bis(2,4-pentanedionate), titanium tri-n-butoxide stearate, bis(cyclopentadienyl)hafnium dichloride, bis(cyclopentadienyl)tungsten dichloride, diacetato[(S)-(-)-2,2'-bis(diphenylphosphino)-1,1'-binaphthyl]ruthenium, dichloro[ethylenebis(diphenylphosphine)] cobalt, titanium butoxide oligomers, aminopropyltrimethoxytitanium, aminopropyltriethoxyzirconium, 2-(3,4-epoxycyclohexyl)ethyltrimethoxyzirconium, γ-glycidoxypropyltrimethoxyzirconium, 3-isocyanopropyltrimethoxyzirconium, 3-isocyanopropyltriethoxyzirconium, triethoxymono(acetylacetonato)titanium, tri-n-propoxymono(acetylacetonato)titanium, tri-i-propoxymono(acetylacetonato)titanium, triethoxymono(acetylacetonato)zirconium, tri-n-propoxymono(acetylacetonato)zirconium, tri-i-propoxymono(acetylacetonato)zirconium, diisopropoxybis(acetylacetonato)titanium, di-n-butoxybis(acetylacetonato)titanium, di-n-butoxybis(acetylacetonato)zirconium, tri(3-methacryloxypropyl)methoxyzirconium, tri(3-acryloxypropyl)methoxyzirconium, tin tetraisopropoxide, tin tetrabutoxide, lanthanum oxide, yttrium oxide, t-butyltris(diethylamide)tin, and the like. Of these, the metal alkoxide and the metal acyloxide are preferred, the metal alkoxide is more preferred, and alkoxides of titanium, zirconium, hafnium, tantalum, tungsten and tin are still more preferred.

In the case of using the organic acid (a) as a constitutive component in synthesizing the compound (A), the lower limit of the amount of the organic acid (a) used is preferably 10 parts by mass, and more preferably 30 parts by mass with respect to 100 parts by mass of the metal-containing compound (b). Meanwhile, the upper limit of the amount of the organic acid used is preferably 1,000 parts by mass, more preferably 700 parts by mass, and still more preferably 500 parts by mass with respect to 100 parts by mass of the metal-containing compound (b). When the amount of the organic acid used falls within the above range, an appropriate adjustment of a percentage content of the organic acid (a) in the compound (A) to be obtained is enabled, thereby consequently enabling the coating characteristics and the storage stability of the radiation-sensitive composition to be more improved.

Upon the synthesis reaction of the compound (A), in addition to the metal compound (I) and the organic acid (a), a compound that may be the polydentate ligand represented by L in the compound of the formula (1), a compound that may be a bridging ligand, etc., may also be added. The compound that may be the bridging ligand is exemplified by a compound having a hydroxy group, an isocyanate group, an amino group, an ester group and an amide group each in a plurality of number, and the like.

A procedure for carrying out the hydrolytic condensation reaction using the metal-containing compound (b) may be exemplified by: a procedure of hydrolytically condensing the metal-containing compound (b) in a solvent containing water; and the like. In this case, other compound having a hydrolyzable group may be added as needed. The lower limit of the amount of water used for the hydrolytic condensation reaction is preferably 0.2 times molar amount, more preferably an equimolar amount, and still more preferably 3 times molar amount with respect to the hydrolyzable group included in the metal-containing compound (b) and the like. The upper limit of the amount of water is preferably 20 times molar amount, more preferably 15 times molar amount, and further more preferably 10 times molar amount. When the amount of the water in the hydrolytic condensation reaction falls within the above range, it is possible to increase the percentage content of the metal oxide in the compound (A) to be obtained, thereby consequently enabling the coating characteristics and the storage stability of the radiation-sensitive composition to be more improved.

The solvent for use in the synthesis reaction of the compound (A) is not particularly limited, and solvents similar to those exemplified in connection with the solvent (B) described later may be used. Of these, alcohol solvents, ether solvents, ester solvents, and hydrocarbon solvents are preferred; alcohol solvents, ether solvents and ester solvents are more preferred; polyhydric alcohol partial ether solvents, monocarboxylic acid ester solvents and cyclic ether solvents are still more preferred; and propylene glycol monomethyl ether, ethyl lactate and propylene glycol monomethyl ether acetate are particularly preferred.

In the case of using the solvent in the synthesis reaction of the compound (A), the solvent used may be either removed after the completion of the reaction, or directly used as the solvent (B) in the radiation-sensitive composition without removal thereof.

The lower limit of the temperature of the synthesis reaction of the compound (A) is preferably 0 °C, and more preferably 10 °C. The upper limit of the aforementioned temperature is preferably 150 °C, and more preferably 100 °C.

The lower limit of the time period of the synthesis reaction of the compound (A) is preferably 1 min, more preferably 10 min, and still more preferably 1 hour. The upper limit of the time period is preferably 100 hrs, more preferably 50 hrs, and further more preferably 10 hrs.

### (B) Solvent

The solvent (B) dissolves or disperses the compound (A), and optional component(s) contained as needed. The solvent (B) contains a first solvent (hereinafter, may be also referred to as "(B1) solvent" or "solvent (B1)") and a second solvent (hereinafter, may be also referred to as "(B2) solvent" or "solvent (B2)"). The solvent (B1) has a viscosity at 20 °C of no greater than 10 mPa·s, and a vapor pressure at 20 °C of no greater than 5 kPa. The solvent (B2) is a component distinct from the solvent (B1), and has a van der Waals volume of no greater than 150 Å³. Meanwhile, solvent (B2) is water, a monovalent alcohol represented by R¹-OH, R²-COOH or a combination thereof, wherein R¹ represents a monovalent organic group having no less than 1 and no greater than 4 carbon atoms, and R² represents a monovalent organic group having no less than 1 and no greater than 30 carbon atoms.

The radiation-sensitive composition is superior in the coating characteristics and the storage stability. Although not necessarily clarified and without wishing to be bound by any theory, the reason for achieving the effects described above owing to the radiation-sensitive composition having the aforementioned constitution may be inferred as follows, for example. More specifically, favorable miscibility of the solvent (B) with the compound (A) is attained in the radiation-sensitive composition due to the solvent (B1) included in the solvent (B), and as a result, aggregation of the compound (A) is inhibited, whereby the storage stability of the radiation-sensitive composition can be improved. In addition, appropriate viscosity is provided due to a combination of the solvent (B1) and the solvent (B2) as the solvent (B), and as a result, the coating characteristics of the radiation-sensitive composition can be improved.

The solvent (B1) and the solvent (B2) may be used each alone or in combination of two or more types thereof. As the solvent (B), an organic solvent used in synthesizing the compound (A) may be employed. Hereinafter, each component is explained in detail. It is to be noted that "normal boiling point" (hereinafter, may be merely referred to as "boiling point") as referred to means a boiling point at one atmospheric pressure.

### (B1) Solvent

The solvent (B1) has a viscosity at 20 °C of no greater than 10 mPa·s, and a vapor pressure at 20 °C of no greater than 5 kPa. The upper limit of the viscosity at 20 °C of the solvent (B1) is preferably 10 mPa·s, and more preferably 5 mPa·s. The lower limit of the viscosity at 20 °C of the solvent (B1) is preferably 0.3 mPa·s, and more preferably 0.5 mPa·s. When the viscosity of the solvent (B1) falls within the above range, the coating characteristics can be improved. In addition, the upper limit of the vapor pressure of the solvent (B1) is preferably 5 kPa, and more preferably 3 kPa. The lower limit of the vapor pressure of the solvent (B1) is preferably 0.01 kPa, and more preferably 0.5 kPa. When the vapor pressure of the solvent (B1) falls within the above range, the coating characteristics can be improved.

The lower limit of the normal boiling point of the solvent (B1) is preferably 120 °C, and more preferably 130 °C. Furthermore, the upper limit of a normal boiling point of the solvent (B1) is preferably 175 °C, and more preferably 165 °C. When the normal boiling point of the solvent (B1) falls within the above range, the solubility of the compound (A) can be improved, thereby enabling the storage stability of the radiation-sensitive composition to be improved.

The solvent (B1) is exemplified by ketones, esters, ethers, carbonates, alcohols, amides, aromatic hydrocarbons and the like. Of these, the solvent (B1) is preferably a ketone, an ester, an ether, a carbonate, a monovalent alcohol having no less than 5 carbon atoms, an alcohol having a valency of no less than 2, or a combination thereof, more preferably a lactic acid alkyl ester, an alkylene glycol alkyl ether, an alkylene glycol alkyl ether acetate, a cyclic ketone, an alkoxypropionic acid alkyl ester or a combination thereof, and still more preferably propylene glycol monoethyl ether (boiling point: 133 °C), propylene glycol monomethyl ether acetate (boiling point: 146 °C), cyclohexanone (boiling point: 156 °C), ethyl 3-ethoxypropionate (boiling point: 166 °C), ethyl lactate (boiling point: 151 °C) or 4-methyl-2-pentanol (boiling point: 132 °C).

Due to the solvent containing the solvent (B1), the coating characteristics and the storage stability of the radiation-sensitive composition can be more improved.

### (B2) Solvent

The solvent (B2) is a component that is distinct from the solvent (B1), and is a solvent having a van der Waals volume of no greater than 150 Å³. The upper limit of the van der Waals volume of the solvent (B1) is preferably 150 Å³, and more preferably 100 Å³. The lower limit of the van der Waals volume of the solvent (B1) is preferably 15 Å³, and more preferably 20 Å³. When the van der Waals volume of the solvent (B1) falls within the above range, the coating characteristics and the storage stability of the radiation-sensitive composition can be more improved. It is to be noted that the "van der Waals volume of a solvent" as referred to herein means a van der Waals volume of molecules constituting the solvent.

The solvent (B2) is water, a monovalent alcohol represented by R¹-OH, R²-COOH or a combination thereof, wherein R¹ represents a monovalent organic group having no less than 1 and no greater than 4 carbon atoms, and R² represents a monovalent organic group having no less than 1 and no greater than 30 carbon atoms.

The monovalent organic group having 1 to 4 carbon atoms represented by R¹ is exemplified by: a monovalent hydrocarbon group having 1 to 4 carbon atoms; a monovalent group (g) that includes a divalent hetero atom-containing group between two adjacent carbon atoms of the monovalent hydrocarbon group, or at the end of the atomic bonding side of the monovalent hydrocarbon group; a monovalent group obtained from the monovalent hydrocarbon group or the group (g) by substituting with a monovalent hetero atom-containing group a part or all of hydrogen atoms included therein; and the like.

Examples of the monovalent hydrocarbon group having 1 to 4 carbon atoms include groups having a chain hydrocarbon group, e.g.:
alkyl groups such as a methyl group, an ethyl group, a propyl group and a butyl group;
alkenyl groups such as an ethenyl group, a propenyl group and a butenyl group;
alkynyl groups such as an ethynyl group, a propynyl group and a butynyl group; and the like.

Examples of the divalent hetero atom-containing group include -CO-, -NH-, -O-, groups obtained by combining the same, and the like.

The monovalent hetero atom-containing group is exemplified by a hydroxy group, a halogen atom and the like.

Of these, the monovalent organic group having 1 to 4 carbon atoms represented by R¹ is preferably a methyl group, an ethyl group, a n-propyl group, an iso-propyl group, an isobutyl group, a sec-butyl group, a tert-butyl group, a 2-methyl-1-propyl group or a 1-methoxy-2-propyl group.

The monovalent organic group having 1 to 30 carbon atoms represented by R² is exemplified by: a monovalent hydrocarbon group having 1 to 30 carbon atoms; a monovalent group (g) that includes a divalent hetero atom-containing group between two adjacent carbon atoms of the monovalent hydrocarbon group, or at the end of the atomic bonding side of the monovalent hydrocarbon group; a monovalent group obtained from the monovalent hydrocarbon group or the group (g) by substituting with a monovalent hetero atom-containing group a part or all of hydrogen atoms included therein; and the like.

Examples of the monovalent hydrocarbon group having 1 to 30 carbon atoms include chain hydrocarbon groups, e.g.:
alkyl groups such as a methyl group, an ethyl group, a propyl group, a butyl group and a pentyl group;
alkenyl groups such as an ethenyl group, a propenyl group and a butenyl group; and
alkynyl groups such as an ethynyl group, a propynyl group and a butynyl group,
alicyclic hydrocarbon groups, e.g.,
cycloalkyl groups such as a cyclopentyl group and a cyclohexyl group;
cycloalkenyl groups such as a cyclopropenyl group, a cyclopentenyl group and a cyclohexenyl group; and
bridged cyclic hydrocarbon groups such as a norbornyl group and an adamantyl group,
groups having an aromatic hydrocarbon group, e.g.,
aryl groups such as a phenyl group, a tolyl group, a xylyl group and a naphthyl group;
aralkyl groups such as a benzyl group, a phenethyl group and a naphthylmethyl group; and
a styryl group, a styryl methyl group, an acenaphthyl group and an acenaphthylmethyl group; and the like.

Examples of the divalent hetero atom-containing group and the monovalent hetero atom-containing group include groups similar to those exemplified as the groups represented by R¹, and the like.

Of these, as the monovalent organic group having 1 to 30 carbon atoms represented by R², a methyl group and an ethyl group are preferred.

The upper limit of the viscosity at 20 °C of the solvent (B2) is preferably 4 mPa·s, and more preferably 3 mPa·s. The lower limit of the viscosity is preferably 0.5 mPa·s, and more preferably 1 mPa·s. When the viscosity of the solvent (B2) falls within the above range, the coating characteristics of the radiation-sensitive composition can be more improved.

Examples of the solvent (B2) include methanol, ethanol, 1-propanol, 2-propanol, 1-butanol, 2-butanol, 2-methyl-1-propanol, propylene glycol monomethyl ether, water, acetic acid, propionic acid, acrylic acid, methacrylic acid, trifluoroacetic acid and the like. Of these, methanol, ethanol, 1-propanol, 1-butanol, 2-methyl-1-propanol, propylene glycol monomethyl ether, water, acetic acid and propionic acid are preferred.

The solvent (B) may contain other organic solvent component than the solvent (B1) and the solvent (B2) within a range not leading to impairment of the effects of the present invention. One, or two or more types of the other organic solvent component than the solvent (B1) and the solvent (B2) may be contained.

The lower limit of the content of the solvent (B1) in the solvent (B) is preferably 25% by mass, more preferably 30% by mass, still more preferably 35% by mass, and particularly preferably 50% by mass. The upper limit of the content of the solvent (B1) is preferably 99% by mass, and more preferably 90% by mass. The lower limit of the content of the solvent (B2) in the solvent (B) is preferably 1% by mass, and more preferably 10% by mass. The upper limit of the content of the solvent (B2) is preferably 75% by mass, more preferably 70% by mass, still more preferably 65% by mass, and particularly preferably 50% by mass. When the contents of the solvent (B1) and the solvent (B2) fall within the above ranges, the coating characteristics and the storage stability of the radiation-sensitive composition can be more improved. Moreover, the total content of the solvent (B1) and the solvent (B2) in the solvent (B) may be 100% by mass.

### Optional Components

The radiation-sensitive composition may contain in addition to the component (A) and the component (B) as optional components, for example, (C) a radiation-sensitive acid generator, (D) an acid diffusion controller, a fluorine atom-containing polymer, a surfactant and the like. The radiation-sensitive composition one, or two or more types of each optional component.

### (C) Acid Generator

The acid generator (C) is a component that generates an acid upon an irradiation with a radioactive ray. When the radiation-sensitive composition contains the acid generator (C), replacement between an anion (conjugated base) of the acid generated from the acid generator (C) and the organic acid (a) being present on the periphery of a plurality of compounds (A) occurs, thereby consequently enabling the solubility of the compound (A) in a developer solution and the like to be changed. The acid generator (C) may be contained in the radiation-sensitive composition in the form of a low-molecular weight compound (hereinafter, referred to as "(C) acid generating agent" as appropriate) or in the form incorporated as a part of the compound (A), fluorine atom-containing polymer, etc., or may be in both of these forms.

Examples of the acid generating agent (C) include onium salt compounds such as a sulfonium salt and an iodonium salt, an N-sulfonyloxyimide compound, a halogen-containing compound, a diazo ketone compound, and the like.

The acid generating agent (C) is preferably an onium salt compound or an N-sulfonyloxyimide compound, more preferably a sulfonium salt or an N-sulfonyloxyimide compound, still more preferably a triphenylsulfonium salt or an N-sulfonyloxyimide compound, and particularly preferably triphenylsulfonium nonafluoro-n-butane-1-sulfonate, N-(trifluoromethanesulfonyloxy)bicyclo[2.2.1]hept-5-ene-2,3-dicarboxyimide or (1,3-dioxoisoindolin-2-yl)trifluoromethanesulfonate.

In a case in which the radiation-sensitive composition contains the acid generating agent (C), the lower limit of the content of the acid generating agent (C) with respect to 100 parts by mass of the compound (A) is preferably 0.1 parts by mass, more preferably 1 part by mass, and still more preferably 5 parts by mass. The upper limit of the content is preferably 30 parts by mass, more preferably 20 parts by mass, and still more preferably 10 parts by mass. When the content of the acid generating agent (C) falls within the above range, the radiation-sensitive composition is capable of achieving a more improved resolution.

### (D) Acid Diffusion Controller

The acid diffusion controller (D) controls a phenomenon of diffusion of the acid, which was generated from the acid generator (C), etc. upon the exposure, in the resist film, whereby the effect of inhibiting unwanted chemical reactions in an unexposed region is exhibited. In addition, the storage stability of the radiation-sensitive composition is more improved and the resolution thereof is more improved. Moreover, variation of the line width of the pattern caused by variation of post-exposure time delay from the exposure until a development treatment can be suppressed, which enables the radiation-sensitive composition with superior process stability to be obtained. The acid diffusion controller (D) may be contained in the radiation-sensitive composition in the form of a free compound (hereinafter, may be referred to as "acid diffusion control agent (D)" as appropriate) or in the form incorporated as a part of the compound (A), the fluorine atom-containing polymer, etc., or may be in both of these forms.

The acid diffusion control agent (D) is exemplified by a nitrogen-containing compound and the like. Examples of the nitrogen-containing compound include n-hexylamine, di-n-butylamine, triethylamine, aniline, ethylenediamine, polyethyleneimine, polyallylamine, dimethylaminoethylacrylamide, formamide, acetamide, propionamide, benzamide, pyrrolidone, urea, pyridine, pyrazine, pyrazole, and the like.

As the acid diffusion control agent (D), a photodegradable base may be used which generates a weak acid upon an irradiation with a radioactive ray. The photodegradable base is exemplified by an onium salt compound that loses acid diffusion controllability through degradation upon an exposure, and the like. Examples of the onium salt compound include a sulfonium salt compound represented by the following formula (6-1), an iodonium salt compound represented by the following formula (6-2), and the like.

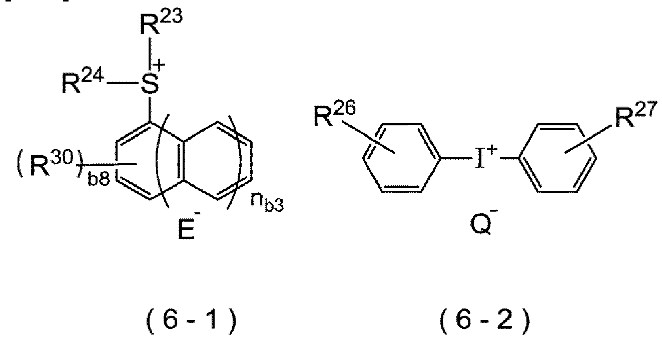

In the above formula (6-1), R²³ and R²⁴ each independently represent a monovalent organic group having 1 to 20 carbon atoms; R³⁰ represents a monovalent organic group having 1 to 20 carbon atoms, a hydroxy group, a nitro group or a halogen atom; b8 is an integer of 0 to 5, wherein in a case in which there exists a plurality of R³⁰s, the plurality of R³⁰s may be identical or different, and a plurality of R³⁰s may taken together represent a ring structure; and n_{b3} is an integer of 0 to 3.

The monovalent organic group having 1 to 20 carbon atoms which may be represented by R²³, R²⁴ or R³⁰ is exemplified by: a monovalent hydrocarbon group having 1 to 20 carbon atoms; a monovalent group (g) having a divalent hetero atom-containing group between two adjacent carbon atoms or the end of the atomic bonding side of the hydrocarbon group having 1 to 20 carbon atoms; a monovalent group obtained by substituting with a hetero atom-containing group, a part or all of hydrogen atoms included in the hydrocarbon group and the group (g); and the like.

R²³ and R²⁴ each independently represent preferably a monovalent unsubstituted hydrocarbon group having 1 to 20 carbon atoms, or a hydrocarbon group a hydrogen atom of which is substituted with a substituent, more preferably a monovalent unsubstituted aromatic hydrocarbon group having 6 to 18 carbon atoms, or an aromatic hydrocarbon group a hydrogen atom of which is substituted with a substituent, and still more preferably a phenyl group.

As the substituent which may substitute for the hydrogen atom included in the monovalent hydrocarbon group having 1 to 20 carbon atoms which may be represented by R²³ or R²⁴, a substituted or unsubstituted monovalent hydrocarbon group having 1 to 20 carbon atoms, -OSO₂-R^{q}, -SO₂-R^{q}, -OR^{q}, -COOR^{q}, -O-CO-R^{q}, -O-R^{qq}-COOR^{q}, -R^{qq}-CO-R^{q} and -S-R^{q}a are preferred, wherein R^{q} represents a monovalent hydrocarbon group having 1 to 10 carbon atoms; and R^{qq} represents a single bond or divalent hydrocarbon group having 1 to 10 carbon atoms.

R³⁰ represents preferably a substituted or unsubstituted monovalent hydrocarbon group having 1 to 20 carbon atoms, -OSO₂-R^{q}, -SO₂-R^{q}, -OR^{q}, -COOR^{q}, -O-CO-R^{q}, -O-R^{qq}-COOR^{q}, -R^{qq}-CO-R^{q} or -S-R^{q}, wherein R^{q} represents a monovalent hydrocarbon group having 1 to 10 carbon atoms; and R^{qq} represents a single bond or divalent hydrocarbon group having 1 to 10 carbon atoms.

In the above formula (6-2), R²⁶ to R²⁷ each independently represent a monovalent organic group having 1 to 20 carbon atoms, a hydroxy group, a nitro group or a halogen atom.

As R²⁶ and R²⁷, a substituted or unsubstituted monovalent hydrocarbon group having 1 to 20 carbon atoms, -OSO₂-R^{q}, -SO₂-R^{q}, -OR^{q}, -COOR^{q}, -O-C-R^{q}, -O-R^{qq}-COOR^{q}, -R^{qq}-CO-R^{q}, -S-R^{q} and a ring structure taken together represented by at least two of these groups are preferred, wherein R^{q} represents a monovalent hydrocarbon group having 1 to 10 carbon atoms; and R^{qq} represents a single bond or divalent hydrocarbon group having 1 to 10 carbon atoms.

Examples of the monovalent hydrocarbon group having 1 to 20 carbon atoms which may be represented by R³⁰, R²⁶ or R²⁷ include, among the monovalent hydrocarbon groups exemplified as the group represented by R², those having 1 to 20 carbon atoms, and the like.

Examples of the substituent which may substitute for the hydrogen atom included in the hydrocarbon group which may be represented by R³⁰, R²⁶ or R²⁷ include halogen atoms such as a fluorine atom, a chlorine atom, a bromine atom and an iodine atom, a hydroxy group, a carboxy group, a cyano group, a nitro group, an alkoxy group, an alkoxycarbonyl group, an alkoxycarbonyloxy group, an acyl group, an acyloxy group, and the like.

As the R³⁰, R²⁶ and R²⁷, an unsubstituted linear or branched monovalent alkyl group, a monovalent fluorinated alkyl group, an unsubstituted monovalent aromatic hydrocarbon group, -OSO₂-R^{q} and -SO₂-R^{q} are preferred, a fluorinated alkyl group and an unsubstituted monovalent aromatic hydrocarbon group are more preferred, and a fluorinated alkyl group is still more preferred.

In the above formulae (6-1) and (6-2), E⁻ and M⁻ each independently represent OH⁻, R^{β}-COO⁻, R^{γ}-SO₃⁻ or an anion represented by the following formula (6b-3), wherein R^{β} represents an alkyl group, an aryl group or an aralkyl group; and R^{γ} represents an alkyl group or an aralkyl group.

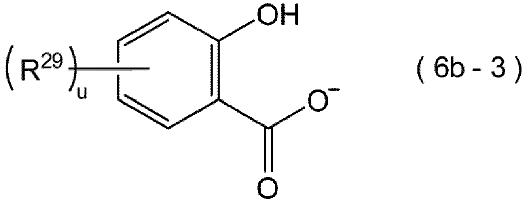

In the above formula (6b-3), R²⁹ represents a linear or branched alkyl group having 1 to 12 carbon atoms, a linear or branched fluorinated alkyl group having 1 to 12 carbon atoms or a linear or branched alkoxy group having 1 to 12 carbon atoms; and u is an integer of 0 to 2, wherein in a case in which u is 2, two R²⁹s are identical or different.

The photolabile base is preferably a sulfonium salt, more preferably a triaryl sulfonium salt, and still more preferably triphenylsulfonium salicylate.

In a case in which the radiation-sensitive composition contains the acid diffusion control agent (D), the lower limit of the content of the acid diffusion control agent (D) with respect to 100 parts by mass of the compound (A) is preferably 0.1 parts by mass, more preferably 0.3 parts by mass, and still more preferably 1 part by mass. The upper limit of the content is preferably 20 parts by mass, more preferably 10 parts by mass, and still more preferably 5 parts by mass. When the content of the acid diffusion control agent (D) falls within the above range, the radiation-sensitive composition is capable of achieving an improved resolution.

### Fluorine Atom-Containing Polymer

When the radiation-sensitive composition contains the fluorine atom-containing polymer, in forming the film, the fluorine atom-containing polymer tends to be localized in the surface region of the film due to oil-repellent characteristics thereof in the film. Thus, preventing the radiation-sensitive acid generator, the acid diffusion controller and the like used in liquid immersion lithography, etc., from elution into the liquid immersion medium is enabled. Moreover, due to the water-repellent characteristics of the fluorine atom-containing polymer, an advancing contact angle of a liquid immersion medium on the film can be controlled to fall within a desired range, thereby enabling generation of bubble defects to be inhibited. Furthermore, a greater receding contact angle of the liquid immersion medium on the film is attained, whereby an exposure by high-speed scanning without being accompanied by residual water beads is enabled. Accordingly, when the radiation-sensitive composition contains the fluorine atom-containing polymer, formation of a film suitable for liquid immersion lithography is enabled.

In the case in which the radiation-sensitive composition contains the fluorine atom-containing polymer, the lower limit of the content of the fluorine atom-containing polymer with respect to 100 parts by mass of the compound (A) is preferably 0.1 parts by mass, more preferably 0.5 parts by mass, and still more preferably 1 part by mass. The upper limit of the content is preferably 20 parts by mass, more preferably 15 parts by mass, and still more preferably 10 parts by mass.

### Surfactant

The surfactant exerts the effect of improving the coating property, striation, developability, and the like. Examples of the surfactant include: nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate and polyethylene glycol distearate; and the like. Examples of the commercially available product of the surfactant include KP341 (Shin-Etsu Chemical Co., Ltd.), Polyflow No. 75 and Polyflow No. 95 (all available from Kyoeisha Chemical Co., Ltd.), EFTOP EF301, EFTOP EF303 and EFTOP EF352 (all available from Tochem Products Co. Ltd.), Megaface F171 and Megaface F173 (all available from DIC, Corporation), Fluorad FC430 and Fluorad FC431 (all available from Sumitomo 3M Limited), ASAHI GUARD AG710, Surflon S-382, Surflon SC-101, Surflon SC-102, Surflon SC-103, Surflon SC-104, Surflon SC-105 and Surflon SC-106 (all available from Asahi Glass Co., Ltd.), and the like.

In the case in which the radiation-sensitive composition contains the surfactant, the lower limit of the content of the surfactant with respect to 100 parts by mass of the compound (A) is preferably 0.1 parts by mass, and more preferably 0.3 parts by mass. The upper limit of the content is preferably 2 parts by mass, and more preferably 1 part by mass.

### Preparation Procedure of Radiation-Sensitive Composition

The radiation-sensitive composition may be prepared, for example, by mixing at a certain ratio, the compound (A), solvent (B), as well as if necessary, the optional component, preferably followed by filtering a mixture thus obtained through a membrane filter, etc. having a pore size of about 0.2 µm. The lower limit of the solid content concentration of the radiation-sensitive composition is preferably 0.1% by mass, more preferably 0.5% by mass, still more preferably 1% by mass, and particularly preferably 1.5% by mass. The upper limit of the solid content concentration is preferably 50% by mass, more preferably 30% by mass, still more preferably 10% by mass, and particularly preferably 5% by mass.

The radiation-sensitive composition may be used: for a development with an alkali in which an alkaline aqueous solution is used as a developer solution; or for a development with an organic solvent in which an organic solvent-containing liquid is used as a developer solution.

### Pattern-Forming Method

The pattern-forming method of the embodiment of the invention includes the steps of: applying the radiation-sensitive composition described above directly or indirectly on one face side of a substrate (hereinafter, may be also referred to as "applying step"); exposing with an extreme ultraviolet ray or an electron beam, a film provided after the applying (hereinafter, may be also referred to as "exposure step"); and developing the film exposed (hereinafter, may be also referred to as "development step"). Since the radiation-sensitive composition of the embodiment of the present invention is used, the pattern-forming method enables a pattern to be formed with superior sensitivity accompanied by superior storage stability and stability of the sensitivity in laying post film-forming. Each step will be described below.

### Applying Step

In this step, the radiation-sensitive composition is applied directly or indirectly on one face side of a substrate. The application procedure is not particularly limited, and application means such as e.g., spin-coating, cast coating or roll coating may be employed. The substrate is exemplified by a silicon wafer, a wafer coated with aluminum, and the like. Specifically, after the radiation-sensitive composition is applied such that the resultant film has a predetermined thickness, prebaking (PB) is executed as needed to evaporate off the solvent in the coating film.

The lower limit of the average thickness of the film is preferably 1 nm, more preferably 10 nm, still more preferably 20 nm, and particularly preferably 30 nm. The upper limit of the average thickness is preferably 1,000 nm, more preferably 200 nm, still more preferably 100 nm, and particularly preferably 70 nm.

The lower limit of the temperature of PB is preferably 60 °C, and more preferably 80 °C. The upper limit of the temperature of PB is preferably 140 °C, and more preferably 120 °C. The lower limit of the time period of PB is preferably 5 sec, and more preferably 10 sec. The upper limit of the time period of PB is preferably 600 sec, and more preferably 300 sec.

### Exposure Step

In this step, the film formed by the applying step is exposed. The exposure is carried out by irradiating with a radioactive ray through a mask having a predetermined pattern via a liquid immersion medium such as water, as the case may be. Examples of the radioactive ray include: electromagnetic waves such as a visible light ray, an ultraviolet ray, a far ultraviolet ray, an extreme ultraviolet ray (EUV; wavelength: 13.5 nm), an X-ray and a γ-ray; charged particle rays such as an electron beam and an α-ray; and the like. Of these, radioactive rays that allow more secondary electrons to be released from the metal atom included in the compound (A) and the like by the exposure are preferred, and EUV and an electron beam are more preferred.

In addition, post exposure baking (PEB) may be carried out after the exposure. The lower limit of the temperature of PEB is preferably 50 °C, and more preferably 80 °C. The upper limit of the temperature of PEB is preferably 180 °C, and more preferably 130 °C. The lower limit of the time period of PEB is preferably 5 sec, and more preferably 10 sec. The upper limit of the time period of PEB is preferably 600 sec, and more preferably 300 sec.

In the embodiment of the present invention, in order to maximize the potential ability of the radiation-sensitive composition, for example, an organic or inorganic antireflective film may be formed on the substrate employed. In addition, in order to prevent influences of basic impurities etc., included in the environment atmosphere, a protective film may be also provided on the coating film, for example. Furthermore, in a case where an exposure by way of liquid immersion is carried out, in order to avoid direct contact of the film with the liquid immersion medium, a protective film for liquid immersion may be also provided on the film, for example.

### Development Step

In this step, the film exposed in the exposure step is developed. A developer solution for use in the development is exemplified by an alkali aqueous solution, an organic solvent-containing liquid, and the like.

Examples of the alkali aqueous solution include alkaline aqueous solutions prepared by dissolving at least one alkaline compound such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide (TMAH), pyrrole, piperidine, choline, 1,8-diazabicyclo-[5.4.0]-7-undecene and 1,5-diazabicyclo-[4.3.0]-5-nonene, and the like.

The lower limit of the content of the alkaline compound in the alkali aqueous solution is preferably 0.1% by mass, more preferably 0.5% by mass, and still more preferably 1% by mass. The upper limit of the content is preferably 20% by mass, more preferably 10% by mass, and still more preferably 5% by mass.

The alkali aqueous solution is preferably an aqueous TMAH solution, and more preferably a 2.38% by mass aqueous TMAH solution.

Exemplary organic solvent in the organic solvent-containing liquid includes those similar to the organic solvents exemplified as the solvent (E) of the radiation-sensitive composition, and the like. Of these, the ester solvents and the ketone solvents are preferred, and butyl acetate and 2-heptanone are more preferred.

The lower limit of the content of the organic solvent in the organic solvent developer solution is preferably 80% by mass, more preferably 90% by mass, still more preferably 95% by mass, and particularly preferably 99% by mass.

These developer solutions may be used either alone of one type, or two or more types thereof in combination. It is to be noted that the development is typically followed by washing with water, etc., and drying.

A positive tone pattern can be obtained when the alkali aqueous solution is used as the developer solution. Whereas a negative tone pattern can be obtained when the organic solvent-containing liquid is used as the developer solution.

### EXAMPLES

Hereinafter, the present invention is explained in detail by way of Examples, but the present invention is not in any way limited to these Examples.

### Synthesis of Compound (A)

### Synthesis Example 1

Into a nitrogen-substituted three-neck flask, 150 mL of ultra pure water was placed and 4.4 g of t-butyltris(diethylamide)tin was added thereto dropwise by using a gas-tight syringe at a rate of about 125 µL/s. Thereafter, the mixture was stirred at room temperature for 30 min, and a slurry thus obtained was filtered in vacuo through a paper filter of grade 1, manufactured by Whatman Inc. The solid thus obtained was washed three times with 50 mL of ultra pure water, and a residual solid was dried under reduced pressure for 8 hrs to give (A) compound (A-1) being particles, with a favorable yield.

### Synthesis Example 2

Into a nitrogen-substituted three-neck flask, 20.0 g of tetrabutyl orthotitanate, 100 mL of tetrahydrofuran and 100 mL of methacrylic acid were placed, and then the mixture was heated to 65 °C. After the mixture was stirred for 20 min, 10.6 g of water was added dropwise over 10 min. After the mixture was stirred at 65 °C for 18 hrs, 10.6 g of water was further added dropwise over 10 min. After the mixture was stirred for 2 hrs, the reaction was stopped by allowing to cool to normal temperature. Particles were precipitated by adding 400 mL of water to the reaction liquid obtained. Thus precipitated particles were subjected to centrifugal separation at 3,000 rpm for 10 min, and the supernatant was decanted. The residual particles were dissolved in 50 g of acetone, and 400 mL of water was added again to permit precipitation. The precipitated particles were subjected to centrifugal separation at 3,000 rpm, and the supernatant was decanted. The particles thus obtained were dried at 10 Pa for 15 hrs to give (A) compound (A-2) being particles, with a favorable yield.

### Synthesis Examples 3 to 6

(A) compounds (A-3) to (A-6) being particles were synthesized by carrying out a similar operation to that of Synthesis Example 2 using metal compounds shown in Table 1 below.

**Table 1**

| (A) Compound | Material | Yield (%) |
|---|---|---|
| A-1 | t-BuSn(NEt₂)₃ | 41 |
| A-2 | Ti(OBu)₄ | 56 |
| A-3 | Zr(OiPr)₄ | 50 |
| A-4 | Hf(OiPr)₄ | 58 |
| A-5 | Ta(OBu)₄ | 52 |
| A-6 | W(OBu)₄ | 53 |

### Synthesis Example 7

Into a nitrogen-substituted three-neck flask, 20.0 g of tetraethyl orthosilicate, 100 mL of tetrahydrofuran and 1 mL of acetic acid were placed, and then the mixture was heated to 65 °C. After the mixture was stirred for 20 min, 10 g of water was added dropwise over 10 min. After the mixture was stirred at 65 °C for 18 hrs, 10 g of water was further added dropwise over 10 min. After the mixture was stirred for 2 hrs, the reaction was stopped by allowing to cool to normal temperature. To the reaction liquid obtained, 200 mL of propylene glycol monoethyl ether was added and vacuum concentration was carried out to give a solution of (A) compound (A-7) having a solid content of 20%. It is to be noted that the absence of residual acetic acid in the solution was ascertained by GC-MS.

### Preparation of Radiation-Sensitive Composition

The solvent (B) and the acid generating agent (C) used for preparing the radiation-sensitive compositions are shown below.
(B1) First Solvent
   B1-1: Propylene glycol monoethyl ether
      viscosity (20 °C): 1.7 mPa·s
      vapor pressure (20 °C): 1 kPa
   B1-2: Propylene glycol monomethyl ether acetate
      viscosity (20 °C): 1.1 mPa·s
      vapor pressure (20 °C): 0.27 kPa
   B1-3: Cyclohexanone
      viscosity (20 °C): 2.0 mPa·s
      vapor pressure (20 °C): 0.59 kPa
   B1-4: Ethyl 3-ethoxypropionate
      viscosity (20 °C): 1.3 mPa·s
      vapor pressure (20 °C): 0.20 kPa
   B1-5: Ethyl lactate)
      viscosity (20 °C): 2.6 mPa·s
      vapor pressure (20 °C): 0.21 kPa
   B1-6: 4-Methyl-2-pentanol
      viscosity (20 °C): 4.1 mPa·s
      vapor pressure (20 °C): 0.70 kPa
(B2) Second Solvent
   B2-1: Methanol
      van der Waals volume: 37.0 Å³
   B2-2: Ethanol
      van der Waals volume: 53.9 Å³
   B2-3: 1-Propanol
      van der Waals volume: 70.9 Å³
   B2-4: 1-Butanol
      van der Waals volume: 87.9 Å³
   B2-5: 2-Methyl-1-propanol
      van der Waals volume: 87.8 Å³
   B2-6: Propylene glycol monomethyl ether van der Waals volume: 96.3 Å³ B2-7: Water
      van der Waals volume: 19.2 Å³
   B2-8: Acetic acid
      van der Waals volume: 56.1 Å³
   B2-9: Propionic acid
      van der Waals volume: 73.1 Å³
   B2-10: 1-Nonanol
      van der Waals volume: 172.9 Å³
   B2-11: 2-Nonanol
      van der Waals volume: 172.8 Å³
   B2-12: Ethylene glycol
      van der Waals volume: 62.1 Å³
   B2-13: Methacrylic acid
      van der Waals volume: 83.1 Å³
(C) Acid Generating Agent
   C-1:(1,3-Dioxoisoindolin-2-yl)trifluoromethanesulfonate (a compound represented by the following formula (C-1))
   C-2: Triphenylsulfonium nonafluoro-n-butane-1-sulfonate (a compound represented by the following formula (C-2))

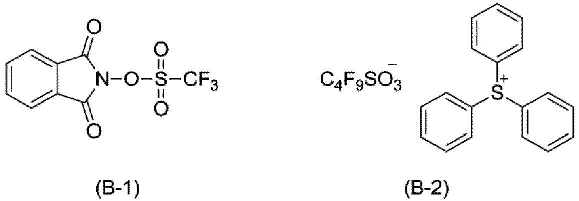

### Preparation Example 1

A radiation-sensitive composition (R-1) was prepared by blending 100 parts by mass of (A-1) as the compound (A), 2,910 parts by mass of (B1-1) as the first solvent (B1), 970 parts by mass of (B2-1) as the second solvent (B2), and 10 parts by mass of (C-1) as the acid generating agent (C), and then filtering the mixture through a 0.2-µm membrane filter.

### Preparation Examples 2 to 37

Radiation-sensitive compositions (R-2) to (R-37) were prepared by a similar operation to that of Preparation Example 1 except that the type and the amount of each component blended were as shown in Table 2 below. In Preparation Example 38, (A-7) was used as the solution in (B1-1), and (B1-2) as the first solvent was further added thereto, whereby the amounts of (B1-1) and (B1-2) were each adjusted as shown in Table 2.

**Table 2**

| | Radiation-sensitive composition | (A) Compound | | (B1) First solvent | | (B2) Second solvent | | (C) Acid generating agent | |
|---|---|---|---|---|---|---|---|---|---|
| | | Type | parts by mass | type | parts by mass | type | parts by mass | type | parts by mass |
| Preparation Example 1 | R-1 | A-1 | 100 | B1-1 | 2910 | B2-1 | 970 | C-1 | 10 |
| Preparation Example 2 | R-2 | A-2 | 100 | B1-1 | 2910 | B2-1 | 970 | C-1 | 10 |
| Preparation Example 3 | R-3 | A-3 | 100 | B1-1 | 2910 | B2-1 | 970 | C-1 | 10 |
| Preparation Example 4 | R-4 | A-4 | 100 | B1-1 | 2910 | B2-1 | 970 | C-1 | 10 |
| Preparation Example 5 | R-5 | A-5 | 100 | B1-1 | 2910 | B2-1 | 970 | C-1 | 10 |
| Preparation Example 6 | R-6 | A-6 | 100 | B1-1 | 2910 | B2-1 | 970 | C-1 | 10 |
| Preparation Example 7 | R-7 | A-1 | 100 | B1-1 | 2910 | B2-2 | 970 | C-1 | 10 |
| Preparation Example 8 | R-8 | A-1 | 100 | B1-1 | 2910 | B2-3 | 970 | C-1 | 10 |
| Preparation Example 9 | R-9 | A-1 | 100 | B1-1 | 2910 | B2-4 | 970 | C-1 | 10 |
| Preparation Example 10 | R-10 | A-1 | 100 | B1-1 | 2910 | B2-5 | 970 | C-1 | 10 |
| Preparation Example 11 | R-11 | A-1 | 100 | B1-1 | 2910 | B2-6 | 970 | C-1 | 10 |
| Preparation Example 12 | R-12 | A-1 | 100 | B1-1 | 3841 | B2-7 | 39 | C-1 | 10 |
| Preparation Example 13 | R-13 | A-1 | 100 | Bl-2 | 2910 | B2-1 | 970 | C-1 | 10 |
| Preparation Example 14 | R-14 | A-1 | 100 | Bl-3 | 2910 | B2-2 | 970 | C-1 | 10 |
| Preparation Example 15 | R-15 | A-1 | 100 | B1-4 | 2910 | B2-2 | 970 | C-1 | 10 |
| Preparation Example 16 | R-16 | A-1 | 100 | B1-5 | 2910 | B2-2 | 970 | C-1 | 10 |
| Preparation Example 17 | R-17 | A-1 | 100 | Bl-2 | 2910 | B2-8 | 970 | C-1 | 10 |
| Preparation Example 18 | R-18 | A-1 | 100 | Bl-2 | 2910 | B2-9 | 970 | C-1 | 10 |
| Preparation Example 19 | R-19 | A-1 | 100 | B1-1 | 3492 | B2-1 | 388 | C-1 | 10 |
| Preparation Example 20 | R-20 | A-1 | 100 | B1-1 | 2328 | B2-1 | 1552 | C-1 | 10 |
| Preparation Example 21 | R-21 | A-1 | 100 | B1-1 | 2328 | B2-1 | 1552 | C-2 | 10 |
| Preparation Example 22 | R-22 | A-1 | 100 | B1-1 | 2910 | B2-1 | 970 | none | none |
| Preparation Example 23 | R-23 | A-1 | 100 | B1-1 | 2910 | B2-10 | 970 | C-1 | 10 |
| Preparation Example 24 | R-24 | A-1 | 100 | B1-1 | 2910 | B2-11 | 970 | C-1 | 10 |
| Preparation Example 25 | R-25 | A-1 | 100 | B1-1 | 2910 | B2-12 | 970 | C-1 | 10 |
| Preparation Example 26 | R-26 | A-1 | 100 | Bl-2 | 2910 | B2-10 | 970 | C-1 | 10 |
| Preparation Example 27 | R-27 | A-1 | 100 | B1-3 | 2910 | B2-10 | 970 | C-1 | 10 |
| Preparation Example 28 | R-28 | A-1 | 100 | B1-4 | 2910 | B2-10 | 970 | C-1 | 10 |
| Preparation Example 29 | R-29 | A-1 | 100 | B1-5 | 2910 | B2-10 | 970 | C-1 | 10 |
| Preparation Example 30 | R-30 | A-1 | 100 | B1-1 | 2910 | B2-10 | 970 | none | none |
| Preparation Example 31 | R-31 | A-2 | 100 | B1-1 | 2910 | B2-10 | 970 | C-1 | 10 |
| Preparation Example 32 | R-32 | A-3 | 100 | B1-1 | 2910 | B2-10 | 970 | C-1 | 10 |
| Preparation Example 33 | R-33 | A-4 | 100 | B1-1 | 2910 | B2-10 | 970 | C-1 | 10 |
| Preparation Example 34 | R-34 | A-5 | 100 | B1-1 | 2910 | B2-10 | 970 | C-1 | 10 |
| Preparation Example 35 | R-35 | A-6 | 100 | B1-1 | 2910 | B2-10 | 970 | C-1 | 10 |
| Preparation Example 36 | R-36 | A-1 | 100 | none | None | B2-1 | 3880 | C-1 | 10 |
| Preparation Example 37 | R-37 | A-1 | 100 | B1-6 | 2910 | B2-1 | 970 | C-1 | 10 |
| Preparation Example 38 | R-38 | A-7 | 100 | B1-1 | 400 | B2-8 | 970 | C-1 | 10 |
| | | | | Bl-2 | 2510 | | | | |
| Preparation Example 39 | R-39 | A-3 | 100 | B1-1 | 2910 | B2-13 | 970 | C-1 | 10 |

### Evaluations

The coating characteristics and the percentage of change in sensitivity of the radiation-sensitive compositions prepared as described above were evaluated according to the following method. The evaluation of a coating characteristic was made on Examples 1 to 24 and Comparative Examples 1 to 15, and the evaluation of the percentage of change in sensitivity was made on Examples 25 to 48 and Comparative Examples 16 to 30. For the measurement of the line-width of the resist pattern, a scanning electron microscope (S-9380, manufactured by Hitachi High-Technologies Corporation) was used.

### Coating Characteristic

The radiation-sensitive compositions prepared as described above were each applied onto the surface of an 8-inch silicon wafer by using a spin coater (CLEAN TRACK ACT8, manufactured by Tokyo Electron Limited), and then subjected to PB at 90 °C for 60 sec, followed by cooling at 23 °C for 30 sec to provide a resist film having a film thickness of 35 nm. Thereafter, the presence/absence of striation (radially running streaks from the center portion toward the peripheral portion) was ascertained by visual inspection, and the evaluation was made to be: "favorable" in the case of the absence of the striation; and "unfavorable" in the case of the presence of the striation. The results of the evaluations of Examples 1 to 24 and Comparative Examples 1 to 15 are shown in Table 3 below.

**Table 3**

| | Radiation-sensitive composition | Coating characteristic |
|---|---|---|
| Example 1 | R-1 | favorable |
| Example 2 | R-2 | favorable |
| Example 3 | R-3 | favorable |
| Example 4 | R-4 | favorable |
| Example 5 | R-5 | favorable |
| Example 6 | R-6 | favorable |
| Example 7 | R-7 | favorable |
| Example 8 | R-8 | favorable |
| Example 9 | R-9 | favorable |
| Example 10 | R-10 | favorable |
| Example 11 | R-11 | favorable |
| Example 12 | R-12 | favorable |
| Example 13 | R-13 | favorable |
| Example 14 | R-14 | favorable |
| Example 15 | R-15 | favorable |
| Example 16 | R-16 | favorable |
| Example 17 | R-17 | favorable |
| Example 18 | R-18 | favorable |
| Example 19 | R-19 | favorable |
| Example 20 | R-20 | favorable |
| Example 21 | R-21 | favorable |
| Example 22 | R-22 | favorable |
| Example 23 | R-37 | favorable |
| Example 24 | R-39 | favorable |
| Comparative Example 1 | R-23 | unfavorable |
| Comparative Example 2 | R-24 | unfavorable |
| Comparative Example 3 | R-25 | unfavorable |
| Comparative Example 4 | R-26 | unfavorable |
| Comparative Example 5 | R-27 | unfavorable |
| Comparative Example 6 | R-28 | unfavorable |
| Comparative Example 7 | R-29 | unfavorable |
| Comparative Example 8 | R-30 | unfavorable |
| Comparative Example 9 | R-31 | unfavorable |
| Comparative Example 10 | R-32 | unfavorable |
| Comparative Example 11 | R-33 | unfavorable |
| Comparative Example 12 | R-34 | unfavorable |
| Comparative Example 13 | R-35 | unfavorable |
| Comparative Example 14 | R-36 | unfavorable |
| Comparative Example 15 | R-38 | unfavorable |

### Evaluation of Storage Stability by Percentage of Change in Sensitivity

The radiation-sensitive compositions shown in Table 4 below were each applied onto the surface of an 8-inch silicon wafer by using a spin coater (CLEAN TRACK ACT8, manufactured by Tokyo Electron Limited), and then subjected to PB at 90 °C for 60 sec, followed by cooling at 23 °C for 30 sec to provide a resist film having an average film thickness of 35 nm. Next, the resist film was irradiated with an electron beam by using a simplified electron beam writer (model "HL800D", manufactured by Hitachi, Ltd., output: 50 KeV; electric current density: 5.0 A/cm²). Next, PEB was carried out at 170 °C for 120 sec on the radiation-sensitive compositions in which (A-1) was used as the metal compound, and at 90 °C for 60 sec on the radiation-sensitive compositions in which (A-2) to (A-6) were used as the metal compound. Development was carried out by using 2-heptanone as an organic developer solution at 23 °C for 30 sec, followed by drying to provide a negative-tone resist pattern. In this step, an exposure dose needed for forming a line-and-space pattern of 150 nm was measured. Next, the radiation-sensitive composition was stored at room temperature (23 ± 1 °C) for two weeks under light shielding. Thereafter, an exposure dose needed for forming a line-and-space pattern of 150 nm was measured again by a similar procedure. The difference between the exposure doses was evaluated as the percentage of change in sensitivity. A smaller percentage of change in sensitivity indicates more favorable storage stability. The results of the evaluations of Examples 25 to 48 and Comparative Examples 16 to 30 are shown in Table 4 below.

**Table 4**

| | Radiation-sensitive composition | Percentage of change in sensitivity |
|---|---|---|
| Example 25 | R-1 | 0% |
| Example 26 | R-2 | 1% |
| Example 27 | R-3 | 0% |
| Example 28 | R-4 | 1% |
| Example 29 | R-5 | 1% |
| Example 30 | R-6 | 1% |
| Example 31 | R-7 | 0% |
| Example 32 | R-8 | 0% |
| Example 33 | R-9 | 0% |
| Example 34 | R-10 | 0% |
| Example 35 | R-11 | 0% |
| Example 36 | R-12 | 1% |
| Example 37 | R-13 | 1% |
| Example 38 | R-14 | 0% |
| Example 39 | R-15 | 1% |
| Example 40 | R-16 | 0% |
| Example 41 | R-17 | 0% |
| Example 42 | R-18 | 0% |
| Example 43 | R-19 | 0% |
| Example 44 | R-20 | 0% |
| Example 45 | R-21 | 0% |
| Example 46 | R-22 | 0% |
| Example 47 | R-37 | 1% |
| Example 48 | R-39 | 0% |
| Comparative Example 16 | R-23 | 8% |
| Comparative Example 17 | R-24 | 7% |
| Comparative Example 18 | R-25 | 14% |
| Comparative Example 19 | R-26 | 15% |
| Comparative Example 20 | R-27 | 17% |
| Comparative Example 21 | R-28 | 17% |
| Comparative Example 22 | R-29 | 14% |
| Comparative Example 23 | R-30 | 7% |
| Comparative Example 24 | R-31 | 12% |
| Comparative Example 25 | R-32 | 14% |
| Comparative Example 26 | R-33 | 14% |
| Comparative Example 27 | R-34 | 12% |
| Comparative Example 28 | R-35 | 10% |
| Comparative Example 29 | R-36 | 11% |
| Comparative Example 30 | R-38 | 13% |

As is clear from the results shown in Table 3 and Table 4, the radiation-sensitive compositions of Examples were superior in the coating characteristic and the storage stability. Meanwhile, the radiation-sensitive compositions of Comparative Examples were inferior in both the coating characteristic and the storage stability.

### [INDUSTRIAL APPLICABILITY]

The radiation-sensitive composition and the resist pattern-forming method of the embodiments of the present invention enable a radiation-sensitive composition superior in the coating characteristics and the storage stability, and a pattern-forming method in which such a radiation-sensitive composition is used to be provided. Therefore, these can be suitably used in manufacture of semiconductor devices in which further progress of miniaturization is expected in the future.

## Claims

1. A radiation-sensitive composition comprising:
a compound comprising a metal-oxygen covalent bond; and
a solvent,
wherein
the metal is a metal of an element belonging to any one of period 4 to period 7 of group 3 to group 15 in periodic table, and
the solvent comprises:
a first solvent having a viscosity at 20 °C of no greater than 10 mPa·s and a vapor pressure at 20 °C of no greater than 5 kPa; and
a second solvent having a van der Waals volume of no greater than 150 Å³, and being different from the first solvent,
the second solvent being: water; a monovalent alcohol represented by R¹-OH; R²-COOH; or a combination thereof, wherein R¹ represents a monovalent organic group having 1 to 4 carbon atoms, and R² represents a monovalent organic group having 1 to 30 carbon atoms.

2. The radiation-sensitive composition according to claim 1, wherein
a content of the first solvent in total of the solvent is no less than 50% by mass and no greater than 90% by mass, and
a content of the second solvent in total of the solvent is no less than 10% by mass and no greater than 50% by mass.

3. The radiation-sensitive composition according to claim 1 or 2, wherein the first solvent is a ketone, an ester, an ether, a carbonate, a monovalent alcohol having no less than 5 carbon atoms, an alcohol having a valency of 2 or more, or a combination thereof.

4. The radiation-sensitive composition according to any one of claims 1 to 3, wherein the second solvent has a viscosity at 20 °C of no greater than 3 mPa·s.

5. The radiation-sensitive composition according to any one of claims 1 to 4, wherein the first solvent has a normal boiling point of no less than 120 °C.

6. The radiation-sensitive composition according to any one of claims 1 to 5, wherein the first solvent is a lactic acid alkyl ester, an alkylene glycol alkyl ether, an alkylene glycol alkyl ether acetate, a cyclic ketone, an alkoxypropionic acid alkyl ester or a combination thereof.

7. The radiation-sensitive composition according to any one of claims 1 to 6, wherein the compound is derived from a metal compound (I) comprising a hydrolyzable group represented by formula (1):
LₐMY_{b} (1)
wherein, in the formula (1),
M represents a metal atom;
L represents a ligand;
a is an integer of 0 to 6, wherein in a case in which a is no less than 2, a plurality of Ls are identical or different;
Y represents a hydrolyzable group selected from a halogen atom, an alkoxy group, a carboxylate group, an acyloxy group and an -NRR group, wherein Rs each independently represent a hydrogen atom or a monovalent organic group having 1 to 20 carbon atoms; and
b is an integer of 2 to 6, wherein a plurality of Ys are identical or different,
the ligand represented by L does not fall under definition of Y.

8. The radiation-sensitive composition according to any one of claims 1 to 7, wherein a solid content concentration of the compound is no less than 50%.

9. A pattern-forming method comprising:
applying the radiation-sensitive composition according to any one of claims 1 to 8 directly or indirectly on a substrate;
exposing a film formed after the applying; and
developing the film exposed.
